Europäisches Patentamt

European Patent Office

Office européen des brevets

(19)

(11) Veröffentlichungsnummer: **0 050 705**
**B1**

(12) **EUROPÄISCHE PATENTSCHRIFT**

(45) Veröffentlichungstag der Patentschrift:
14.11.84

(21) Anmeldenummer: 81104521.0

(22) Anmeldetag: 12.06.81

(51) Int. Cl.³: **G 01 R 15/02**, G 01 R 17/00, G 01 R 19/20

(54) Verfahren und Schaltungsanordnung zur kontaktlosen Messung von Gleich- und Wechselströmen, insbesondere Strom-Augenblickswerten.

(30) Priorität: 25.10.80 DE 3040316

(43) Veröffentlichungstag der Anmeldung:
05.05.82 Patentblatt 82/18

(45) Bekanntmachung des Hinweises auf die Patenterteilung:
14.11.84 Patentblatt 84/46

(84) Benannte Vertragsstaaten:
AT BE CH DE FR GB IT LI LU NL SE

(56) Entgegenhaltungen:
EP - A - 0 006 565
DE - A - 2 601 252
GB - A - 1 566 082

(73) Patentinhaber: GRUNDIG E.M.V. Elektro-Mechanische Versuchsanstalt Max Grundig & Co. KG.,
Kurgartenstrasse 37, D-8510 Fürth (DE)

(72) Erfinder: Fleissner, Horst, Ing. grad., Glogauer Strasse 6, D-8506 Langenzenn (DE)

## Beschreibung

Die Erfindung bezieht sich auf ein Verfahren zur kontaktlosen Messung von Gleich- und Wechselströmen, insbesondere Strom-Augenblickswerten gemäss dem Oberbegriff des Anspruchs 1 sowie eine Schaltungsanordnung hierfür.

Es sind Verfahren zur berührungslosen Messung von Gleichströmen bekannt, bei denen ein geschlossener Eisenkreis vorgesehen ist, der auf den Messleiter aufgesteckt werden muss. Zu diesem Zweck ist der Strompfad stets aufzutrennen.

Auch ist ein mit Feldplatten arbeitendes Verfahren zur kontaktlosen Messung von Gleich- und Wechselströmen bekannt, bei dem ein dem zu messenden Strom in Frequenz und Phase entsprechender Kompensationsstrom verwendet wird (DE-B-27 19073). Ein nach dem in dieser Auslegeschrift beschriebenen Prinzip arbeitendes Messgerät mit Stromzange (Gerät VW 1315 A der Anmelderin) besitzt eine sehr gute Nullpunktstabilität und kann deshalb sehr kleine Ströme messen. Durch das Kompensationsprinzip ist es auch für grosse Ströme geeignet.

Aus der DE-C-28 27 601 sind ein Verfahren zur kontaktlosen Messung von Gleich- und Wechselströmen und eine Anordnung zur Durchführung des Verfahrens gemäss den Merkmalen des Oberbegriffs des Anspruchs 1 bzw. des Anspruchs 9 der vorliegenden Erfindung bekannt. Hierbei sind ein Eisenkern mit Luftspalt mit einer von einem Steuerstrom durchflossenen Feldplatte und mindestens eine von einem Messstrom durchflossene Spule vorgesehen, wobei eine weitere Spule auf dem Eisenkern angeordnet ist. Die durch die dort sich ändernde Durchflutung ergebenden Ist-Änderungen der Feldplattenspannung werden mit Soll-Werten verglichen und eventuelle Abweichungen ausgeregelt.

In der Kfz-Messtechnik wird in letzter Zeit ein Weg gesucht, aus dem Verlauf des Anlasserstroms Informationen über die Kompression in den einzelnen Zylindern zu gewinnen. Dabei besteht das Hauptproblem darin, die einzelnen auftretenden Spitzenwerte, die allgemein über 100 A liegen, berührungslos zu gewinnen. Wegen der erforderlichen Messgeschwindigkeit kommt nur ein direkt messendes Verfahren in Betracht, da das Kompensationsverfahren hierfür zu langsam ist.

Der Erfindung liegt die Aufgabe zugrunde, ein Verfahren und eine Schaltungsanordnung anzugeben, welche eine grosse Messgeschwindigkeit zur Erfassung eines schnellen Augenblickswertes, z. B. auftretender hoher Stromspitzen, ermöglichen, wobei ein herkömmlicher Messumformer unverändert verwendet werden kann. Dabei sollen Strom-Augenblickswerte aller Art gemessen werden können, d. h. von Gleichstrom bis zur Frequenzgrenze des Wandlersystems.

Diese Aufgabe wird erfindungsgemäss durch den Anspruch 1 gelöst.

Eine Schaltungsanordnung zur Durchführung des erfindungsgemässen Verfahrens ist im Anspruch 9 beschrieben.

Weiterbildungen des erfindungsgemässen Verfahrens bzw. der erfindungsgemässen Schaltungsanordnung ergeben sich aus den abhängigen Ansprüchen.

Die Vorteile der Erfindung liegen insbesondere darin, dass bekannte Messwandler (z. B. die obengenannte Stromzange des Gerätes VW 1315 A) unverändert verwendet werden können. Darüber hinaus kann die Steuerung des Messvorganges automatisch erfolgen und mit herkömmlichen Mitteln ohne sonderlichen Aufwand bewerkstelligt werden. Auch kann die Erfindung ohne weiteres bei der Relativmessung der Kompression von Verbrennungsmotoren angewendet werden, wobei vom Verlauf des Anlasserstroms selbst die automatische Steuerung des Messablaufes abgeleitet werden kann.

Ferner überwindet die Erfindung die nachfolgend aufgeführten Schwierigkeiten bei der Erfassung der Ströme:

a) Wegen der Direktmessung wird allgemein ein linearer Übertragungsfaktor benötigt oder ein solcher (z. B. quadratisch), der mit geringem Aufwand in einen linearen umgewandelt werden kann.

b) Wegen der Absolutwert-Messung müssen die Fehler durch Temperaturgang, Luftspaltänderungen, Fremdfelder und Eisensättigung gering gehalten oder nachträglich ausgeglichen bzw. eliminiert werden.

c) Als Messumformer sollen herkömmliche Teile für eine kontaktlose Strommessung, wie z. B. Eisenkreis und Feldplatte, verwendet werden können.

Als wesentlich erweist sich noch, dass die Kurvenform der Wandlerkennlinie in weiten Grenzen beliebig sein kann (Linearität nicht erforderlich) und alle Einflüsse auf den Übertragungsfaktor eliminiert werden, da Messstrom und Ersatzstrom im Wandler gleiche Wirkung auf die Feldplattenspannung haben. Das Eisen darf bis in die Sättigung hinein magnetisiert werden, soweit die Steigung der Übertragungskennlinie für die Genauigkeit ausreicht und die dadurch entstehende Remanenz ein zulässiges Mass nicht übersteigt.

Da der gemessene Strom gleich dem Augenblickswert des Messstroms ist, der ein- und ausgeschaltet wurde, wie z. B. der Anlasserstrom, werden weitere im Messleiter unverändert fliessende Ströme eliminiert.

Als sehr vorteilhaft erweist sich auch der geringe Leistungsbedarf, da der Ersatzstrom nur kurzzeitig fliesst und gering sein kann, weil eine grosse Windungszahl und damit eine grosse Induktivität aus Geschwindigkeitsgründen nicht vermieden werden muss.

Im speziellen Anwendungsfall der Anlasserstrom-Messung zeigen sich als besondere Vorteile, dass die obengenannte bekannte Stromzange oder ähnliche unverändert verwendet und ein Teil der Schaltung des obengenannten Gerätes VW 1315 A mitverwendet werden kann. Somit kann mit nur einer Stromzange ein Gerät geschaffen werden, welches Gleichstrom wie bisher mit grossem Messbereich und sehr guter Nullpunktstabilität und zusätzlich Augenblickswerte messen kann. Dabei entfällt bei Verwendung einer Feldplatte die Polung der Zange bei der Anlasserstrom-Messung; sie arbeitet in beiden Anklemmrichtungen gleich.

Die Erfindung wird nachfolgend unter Bezugnahme auf die Zeichnungsfiguren beispielsweise näher erläutert. Es zeigen

Fig. 1 eine typische Anlasserstromkurve,

Fig. 2 ein Strom/Spannungs-Diagramm an der Feldplatte eines Messwandlers bei verschiedenen Parametern und

Fig. 3 ein Blockschaltbild einer erfindungsgemässen Schaltungsanordnung zur Durchführung des erfindungsgemässen Verfahrens.

Im folgenden wird die Erfindung an einem Ausführungsbeispiel in der Kfz-Messtechnik beschrieben.

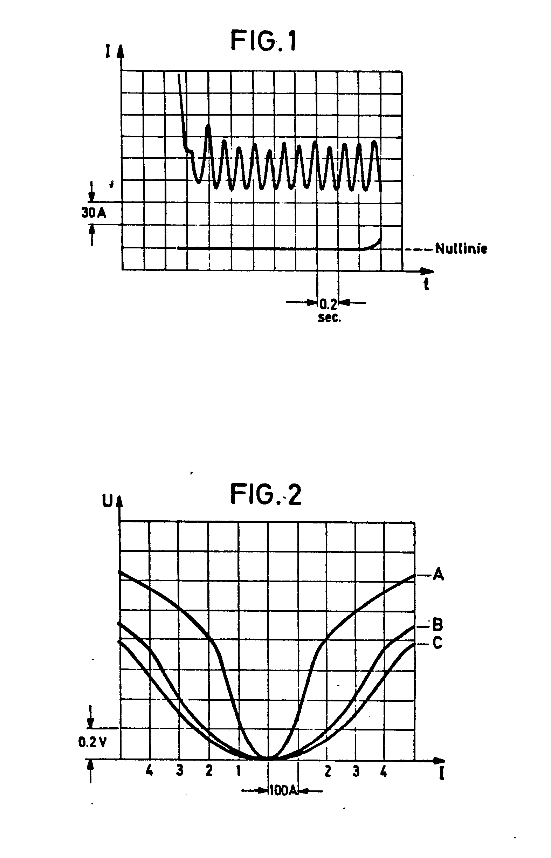

In Fig. 1 ist demnach schematisch eine typische Anlasserstromkurve dargestellt, wobei auf der Abszisse die Zeit (1 Teilstrich entspricht 0,2 sec) und auf der Ordinate der Strom (1 Teilstrich entspricht 30 A) aufgetragen sind.

Fig. 2 zeigt ein Strom/Spannungs-Diagramm an der Feldplatte eines Messumformers, speziell an der Stromzange des bekannten Gerätes VW 1315 A bei verschiedenen Parametern, d. h. die Spannung an der Feldplatte bei konstantem Feldplattenstrom ($I_{FP}$ = const.) und verschiedenen Zusatzluftspalten, abhängig von der Durchflutung bzw. vom Strom bei einer Windung. Auf der Abszisse entspricht 1 Teilstrich 100 A, während auf der Ordinate 1 Teilstrich 0,2 V entspricht.

Dabei gilt die im Diagramm der Fig. 2 dargestellte Kurve A für die unveränderte Stromzange. Bis zum Knick bei ca. 150 A ist der Verlauf quadratisch, darüber ist er durch den Sättigungsbereich des Mumetalls abgeflacht. Die Kurve B gilt gegenüber Kurve A für Zusatzluftspalte von 2 × 0,5 mm, während Kurve C der Stromzange mit zusätzlichen Luftspalten von 2 × 1 mm entspricht und einen quadratischen Verlauf bis über 400 A hat.

Bei derartigen Kennlinien (Kurven A bis C) müsste die Feldplattenspannung durch Wurzelbildung linearisiert werden und wäre nur mit Zusatzluftspalt verwendbar, da die zu messenden Ströme auch über 150 A liegen. Absolute Werte können wegen des grossen Temperaturganges der Feldplatte und wegen des nicht genau einhaltbaren Gesamtluftspalts nur ungenau gemessen werden.

Das Verwenden des (nicht dargestellten) linearen Teils der Feldplatte scheitert daran, dass dazu eine Induktion als Vormagnetisierung nötig wäre, die weit im Sättigungsbereich der meisten Eisensorten liegen würde.

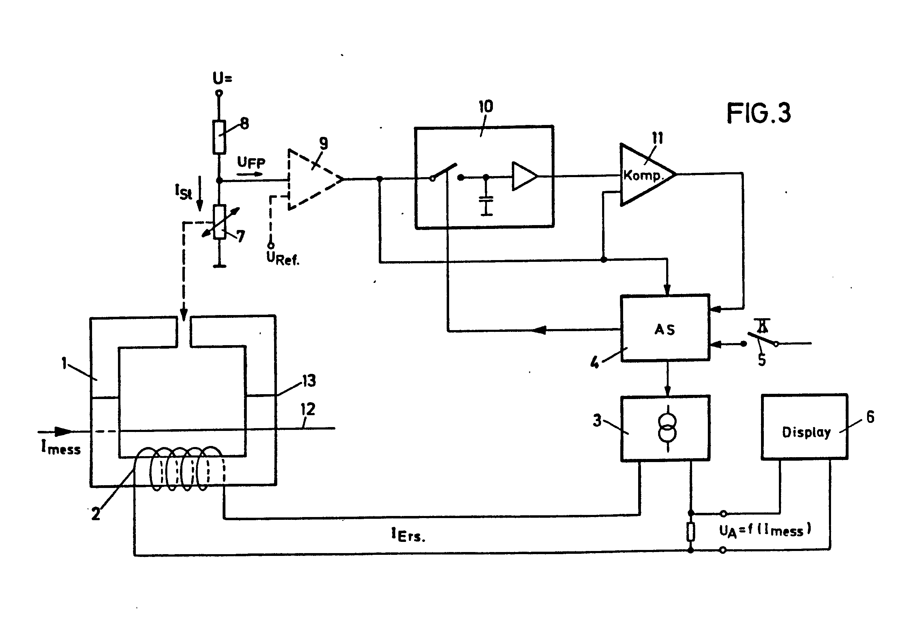

Die Wirkungsweise des erfindungsgemässen Verfahrens, bei dem als Messumformer eine (unveränderte) Stromzange mit Eisenkreis aus Mumetall, einem Luftspalt von ca. 0,7 mm und eine Feldplatte verwendet und die bereits bei der obengenannten Stromzange vorgesehene Kompensationswicklung benötigt wird, wird im folgenden näher beschrieben (s. auch das weiter unten näher beschriebene Blockschaltbild gemäss Fig. 3):

Die Feldplatte kann über einen Vorwiderstand von einer Konstantspannung oder mit Konstantstrom gespeist werden.

Zunächst werden die Feldplatten-Spannungen bei den Spitzenwerten des Anlasserstroms bei stromloser Kompensationswicklung gespeichert. Nach Beendigung des Messstroms wird ein Vergleichsvorgang durchgeführt. Die gespeicherten Spannungen werden nacheinander mit der Feldplatte-Spannung verglichen, während der Strom in einer Wicklung (verwendet wird vorzugsweise die Kompensationswicklung) ansteigt. Sind die Spannungen gleich, ist auch der augenblickliche Strom in der Kompensationswicklung multipliziert mit der Windungszahl gleich dem zugehörigen Messstrom. Unter der Voraussetzung, dass sich der Messwandler zwischen Speicherung und Vergleich nicht verändert hat, was wegen der geringen Zeitdifferenz angenommen werden kann, werden alle Einflüsse auf den Übertragungsfaktor eliminiert, weil Messstrom und Ersatzstrom im Wandler gleiche Wirkung auf die Feldplatten-Spannung haben, wobei die Kurvenform der Wandler-Kennlinie in weiten Grenzen beliebig sein kann. Unterschiedliche Steigungen bedeuten nur unterschiedliche Empfindlichkeiten für den Vergleich.

Wird der ansteigende Strom treppenförmig erhöht, kann dessen binäres Steuersignal direkt die Eingangsdaten für einen Mikroprozessor liefern, der die Messergebnisse weiter auswertet, indem er z. B. eine Verhältnisbildung durchführt.

Ströme, die auf der gleichen Leitung fliessen, haben keinen Einfluss, wenn sie bei Speicherung und nachfolgendem Vergleich unverändert sind; sie sind im Messergebnis nicht enthalten.

Das erfindungsgemässe Verfahren eignet sich zur kontaktlosen Messung von jeder Art Strom-Augenblickswerten, von Gleichstrom bis zur Frequenzgrenze des Wandlers. Grundbedingung ist, dass die beiden Zustände — Messstrom fliesst und Messstrom fliesst nicht — kurz aufeinander folgen.

Fliesst der Messstrom ständig und kein weiterer Strom im Messleiter, muss die Stromzange vom Messleiter genommen werden. Erst dann darf der Ersatzstrom fliessen.

Statt der Feldplatte können auch ein Hallgenerator oder andere magnetfeldabhängige Bauteile verwendet werden. Während bei Verwendung einer Feldplatte der Strom nur in eine Richtung fliessen darf, erlaubt der Hallgenerator die Messung und Anzeige beider Stromrichtungen. Auch mit einem Hallgenerator werden alle Fehler, mit Ausnahme der Eisenremanenz eliminiert, doch stört die Eisenremanenz nur dann, wenn nacheinander Ströme wechselnder Polarität fliessen. Der störende Einfluss kann aber durch Verwendung einer Eisensorte mit kleiner Remanenz kleingehalten werden.

In Verbindung mit einer Feldplatte oder einem Hallgenerator als magnetfeldabhängigem Bauteil können beispielsweise im Eisenkreis ein massiver Eisenkern, ein lamellierter Eisenkern oder ein Ferritkern für höhere Grenzfrequenz verwendet werden.

Zur Steuerung des Ersatzstroms, dessen binäres Steuersignal weiterverarbeitet werden kann, kann in Verbindung mit den oben geschilderten Teilen (Feldplatte, Hallgenerator oder andere magnetfeldabhängige Bauteile und unterschiedlicher Eisenkreis-Aufbau) ein Treppenschrittgenerator vorgesehen werden oder in jeweiliger Verbindung mit allen genannten Ausführungen ein Differenzverstärker, der die Ausgangsspannung des Wandlers ausreichend verstärkt und in einen Bereich verschiebt, der für Speicherung und Vergleich günstig liegt.

Gemäss dem Blockschaltbild zur kontaktlosen Messung von Gleich- und Wechselströmen bzw.

Strom-Augenblickswerten nach Fig. 3 ist ein Eisenkreis 1 vorgesehen, der eine Wicklung 2 für einen Ersatzstrom $I_{Ers}$ einer Stromquelle 3 und eine Trennfuge 13 aufweist. Mit der Stromquelle 3 ist eine Ablaufsteuerung 4 verbunden, an deren einem Eingang — wenn der Vorgang nicht automatisch durchgeführt wird — ein Abfragetaster 5 angeschlossen ist.

An den Ausgangsklemmen der Schaltungsanordnung ist eine Anzeigeeinheit 6 mit Speicher angeschlossen, wobei die Ausgangsspannung eine Funktion des gemessenen Stroms darstellt ($U_A$ = f ($I_{mess}$)).

Im Luftspalt des Eisenkreises 1 ist ein magnetfeldabhängiger Widerstand 7 angeordnet, der mit Masse verbunden ist und über einen Widerstand 8, der an einer Versorgungsgleichspannung angeschlossen ist, mit Strom versorgt wird. Der sich infolge dieses Stromes einstellende Spannungsabfall am magnetfeldabhängigen Widerstand 7, z. B. eine Feldplattenspannung $U_{FP}$, gelangt in einen Analogwertspeicher 10 und an den einen Eingang eines Komparators 11 sowie an einen Eingang der Ablaufsteuerung 4. Zwischen den magnetfeldabhängigen Widerstand 7 und den Analogwertspeicher 10 kann im Bedarfsfalle ein Vorverstärker 9 geschaltet sein, dem neben dem genannten Spannungsabfall noch eine Referenzspannung $U_{Ref}$ zugeführt wird.

Ein Ausgang der Ablaufsteuerung 4 ist mit dem steuerbaren Schaltelement im Analogwertspeicher 10 verbunden, der einmal pro Messwert vorhanden sein muss. Der Ausgang des Analogwertspeichers 10 ist mit dem anderen Eingang des Komparators 11 verbunden, dessen Ausgang an einen weiteren Eingang der Ablaufsteuerung 4 geführt ist.

Ergänzend sei noch erwähnt, dass gemäss Fig. 3 «durch» den Eisenkreis 1 der stromdurchflossene Leiter 12 (Messleiter) verläuft, der nach Öffnen des Eisenkreises eingelegt werden kann und die «analogen» Bauteile (Analogwertspeicher 10 und Analogkomparator 11) im Bedarfsfalle gegen einen Digitalwertspeicher mit vorgeschaltetem Analog-Digital-Umsetzer und einen Digitalkomparator ausgetauscht werden können.

Statt des geschalteten Analogwert-Speichers kann auch ein Spitzenwertspeicher verwendet werden. Diese Ausbildung eignet sich dann besonders zur Messung von Wechselströmen, wenn gleichzeitig ein symmetrisches magnetfeldabhängiges Bauteil wie die Feldplatte eingesetzt wird. Aus dem ermittelten Spitzenwert kann für sinusförmigen Strom der Effektivwert gebildet und angezeigt werden.

**Patentansprüche**

1. Verfahren zur kontaktlosen Messung von Gleich- und Wechselströmen, insbesondere Strom-Augenblickswerten, unter Verwendung eines ferromagnetischen Kreises (1), der einen von dem zu messenden Strom ($I_{mess}$) durchflossenen Leiter (12) umschliesst und der eine Wicklung (2) sowie einen Luftspalt aufweist, in dem ein von einem Steuerstrom ($I_{st}$) durchflossener magnetfeldabhängiger Widerstand (7) angeordnet ist, dadurch gekennzeichnet, dass
— die Spannungsabfälle am magnetfeldabhängigen Widerstand (7) bei den Spitzenwerten oder sonstigen vorgegebenen Werten des zu messenden Stromes ($I_{mess}$) im Leiter (12) bei stromloser Wicklung (2) erfasst und gespeichert werden,
— nach Abschaltung des zu messenden Stroms die gespeicherten Spannungsbfälle nacheinander mit dem Spannungsabfall am magnetfeldabhängigen Widerstand verglichen werden, während ein mit der Zeit ansteigender Ersatzstrom ($I_{Ers}$) durch die Wicklung (2) geschickt wird, und
— bei gleichen Werten der verglichenen Spannungsabfälle der momentane Strom in der Wicklung (2) erfasst und mit der Windungszahl multipliziert als Mass für den zu messenden Strom ($I_{mess}$) ausgewertet wird.

2. Verfahren nach Anspruch 1, dadurch gekennzeichnet, dass der zu messende Strom ($I_{mess}$) bzw. die Strom-Augenblickswerte unter Verwendung einer Feldplatte als magnetfeldabhängiger Widerstand (7) ermittelt werden, die von einer Stromquelle (U=, 8) gespeist wird.

3. Verfahren nach Anspruch 1, dadurch gekennzeichnet, dass der zu messende Strom ($I_{mess}$) bzw. die Strom-Augenblickswerte unter Verwendung eines Hallgenerators als magnetfeldabhängiger Widerstand (7) ermittelt werden.

4. Verfahren nach Anspruch 1 oder 2, dadurch gekennzeichnet, dass für den ferromagnetischen Kreis (1) ein massiver Eisenkern verwendet wird.

5. Verfahren nach Anspruch 1 oder 2, dadurch gekennzeichnet, dass für den ferromagnetischen Kreis (1) ein lamellierter Eisenkern verwendet wird.

6. Verfahren nach Anspruch 1 oder 2, dadurch gekennzeichnet, dass für den ferromagnetischen Kreis (1) ein Ferritkern für höhere Grenzfrequenzen verwendet wird.

7. Verfahren nach einem der vorhergehenden Ansprüche 1 bis 6, dadurch gekennzeichnet, dass ein Treppenschrittgenerator den Ersatzstrom ($I_{Ers}$) steuert.

8. Verfahren nach einem der vorhergehenden Ansprüche 1 bis 7, dadurch gekennzeichnet, dass ein Differenzverstärker (9) die Ausgangsspannung des magnetfeldabhängigen Widerstandes (7) verstärkt und in einen Bereich verschiebt, der für Speicherung und Vergleich geeignet ist.

9. Schaltungsanordnung zur Durchführung des Verfahrens nach einem der Ansprüche 1 bis 8, mit
— einem einen Luftspalt aufweisenden ferromagnetischen Kreis (1), der an den von dem zu messenden Strom ($I_{mess}$) durchflossenen Leiter (12) ankoppelbar ist,
— einer im ferromagnetischen Kreis (1) angeordneten Wicklung (2),
— einer ersten Stromquelle (3) zur Speisung dieser Wicklung (2),
— einem im Luftspalt angeordneten magnetfeldabhängigen Widerstand (7),
— einer zweiter Stromquelle (U=, 8) zur Speisung des Widerstandes (7) mit einem konstanten Steuerstrom ($I_{st}$),
— einer Speichereinheit (10) zur Speicherung des jeweils zu vorgegebenen Zeitpunkten während des Flusses des zu messenden Stroms ($I_{mess}$) am Widerstand (7) auftretenden Spannungsabfalls ($U_{FP}$),

— einem in der Speichereinheit (10) enthaltenen Schaltelement, über das der Spannungsabfall in den Speicher der Speichereinheit (10 eingebbar ist,

— einer Ablaufsteuerung (4) zur Steuerung der Speisung der Wicklung (2) durch die erste Stromquelle (3) und zur Schliessung des Schaltelements zu den vorgegebenen Zeitpunkten,

— einer Anzeigeenheit (6) für die erfassten Werte des zu messenden Stroms ($I_{mess}$),

dadurch gekennzeichnet, dass

— ein Komparator (11) vorgesehen ist, dessen einer Eingang an den Ausgang der Speichereinheit (10) angeschlossen ist und dessen anderer Eingang von dem momentanen Spannungsabfall am Widerstand (7) beaufschlagt ist,

— die Ablaufsteuerung (4) eingangsseitig mit dem momentanen Spannungsabfall und mit dem Ausgangssignal des Komparators (11) verbunden und derart ausgebildet ist, dass in einer ersten, durch die Einschaltzeit des Messstroms ($I_{mess}$) bestimmten Phase die Wicklung (2) stromlos gehalten und die Einspeicherung des Spannungsabfalls durch Schliessen des Schaltelements erfolgt, und dass in einer zweiten Phase nach Abschalten des zu messenden Stroms ($I_{mess}$) die Wicklung (2) mit einem zeitlich ansteigenden Ersatzstrom gespeist und das Schaltelement offengehalten wird, und

— die Anzeigeeinheit (6) zur Anzeige des Ersatzstroms ausgebildet ist.

10. Schaltungsanordnung nach Anspruch 9, dadurch gekennzeichnet, dass für die Speichereinheit (10) und den Komparator (11) ein Analogwertspeicher bzw. Analogkomparator vorgesehen sind.

11. Schaltungsanordnung nach Anspruch 9, dadurch gekennzeichnet, dass für die Speichereinheit (10) und den Komparator (11) ein Digitalwertspeicher bzw. Digitalkomparator mit vorgeschaltetem Analog-Digital-Umsetzer vorgesehen sind.

12. Schaltungsanordnung nach einem der vorhergehenden Ansprüche 9 bis 11, dadurch gekennzeichnet, dass zwischen den magnetfeldabhängigen Widerstand (7) und die Speichereinheit (10) ein Vorverstärker (9) geschaltet ist, dessen einem Eingang der Spannungsabfall am magnetfeldabhängigen Widerstand (7) und dessen anderem Eingang eine Referenzspannung zugeführt ist.

13. Schaltungsanordnung nach den Ansprüchen 9 bis 12, dadurch gekennzeichnet, dass der ferromagnetische Kreis (1) geöffnet werden kann.

14. Schaltungsanordnung nach Anspruch 9, 10, 12, 13 oder 14, dadurch gekennzeichnet, dass für die Speichereinheit (10) ein Spitzenwertspeicher vorgesehen ist.

**Claims**

1. A method for the contactless measuring of direct and alternating currents, especially of instantaneous current values, using a ferro-magnetic circuit (1) which encloses a conductor (12) through which the current ($I_{mess}$) to be measured flows and which is provided with a winding (2) and an air gap in which a resistance (7) is arranged which is dependent on the magnetic field and through which a control current ($I_{st}$) flows, characterised in that

— the voltage drops across the magnetic-field-dependent resistance (7) are detected and stored with a currentless winding (2) when the peak values or other predetermined values of the current ($I_{mess}$) to be measured occur in the conductor (12),

— after the current to be measured is switched off, the voltage drops stored are successively compared with the voltage drops at the magnetic-field-dependent resistance whilst an equivalent current ($I_{Ers}$) which increases with time is passed through the winding (2), and

— with identical values of the compared voltage drops, the instantaneous current in the winding (2) is detected and, multiplied by the number of turns, is analysed as a measure of the current ($I_{mess}$) to be measured

2. A method according to Claim 1, characterised in that the current ($I_{mess}$) to be measured or the instantaneous current values are determined by using a magneto resistor as the magnetic-field-dependent resistance (7) which is fed by a current source (U = , 8).

3. A method according to Claim 1, characterised in that the current ($I_{mess}$) to be measured or the instantaneous current values are determined by using a Hall generator as the magnetic-field-dependent resistance (7).

4. A method according to Claim 1 or 2, characterised in that a solid iron core is used for the ferro-magnetic circuit (1).

5. A method according to Claim 1 or 2, characterised in that a laminated iron core is used for the ferro-magnetic circuit (1).

6. A method according to Claim 1 or 2, characterised in that a ferrite core for higher cut-off frequencies is used for the ferro-magnetic circuit (1).

7. A method according to one of the preceding Claims 1 to 6, characterised in that the equivalent current ($I_{Ers}$) is controlled by a stairstep generator.

8. A method according to one of the preceding Claims 1 to 7, characterised in that the output voltage of the magnetic-field-dependent resistance (7) is amplified and displaced to a range suitable for storage and comparison, by a differential amplifier (9).

9. A circuit arrangement for carrying out the method according to one of Claims 1 to 8, having

— a ferro-magnetic circuit (1) which is provided with air gap and which can be coupled to the conductor (12) through which the current ($I_{mess}$) to be measured flows,

— a winding (2) which is arranged in the ferro-magnetic circuit (1),

— a first current source (3) for feeding this winding (2),

— a magnetic-field-dependent resistance (7) which is arranged in the air gap,

— a second current source (U = , 8) for feeding the resistance (7) with a constant control current ($I_{st}$),

— a storage unit (10) for storing the voltage drop ($U_{FP}$) which occurs at the resistance (7) at pre-

determined times during the flow of each current ($I_{mess}$) to be measured,

— a switching element which is contained in the storage unit (10) and via which the voltage drop can be entered into the memory of the storage unit (10),

— a sequence control unit (4) for controlling the feeding of the winding (2) by the first current supply (3) and for closing the switching element at the predetermined times,

— an indicating unit (6) for the detected values of the current ($I_{mess}$) to be measured,

characterised in that

— a comparator (11) is provided, one input of which is connected to the output of the storage unit (10) and to the other input of which the instantaneous voltage drop across the resistance (7) is applied,

— the input of the sequence control unit (4) is connected to the instantaneous voltage drop and to the output signal of the comparator (11) and is constructed in such a manner that in a first phase, determined by the switch-on time of the current ($I_{mess}$) to be measured, the winding (2) is kept currentless and the voltage drop is stored by closing the switching element, and that in a second phase, after the current ($I_{mess}$) to be measured has been switched off, the winding (2) is fed by an equivalent current which rises with time and the switching element is kept open, and

— the indicating unit (6) is constructed for indicating the equivalent current.

10. A circuit arrangement according to Claim 9, characterised in that an analog-value memory or analog comparator are provided for the storage unit (10) and the comparator (11).

11. A circuit arrangement according to Claim 9, characterised in that a digital-value memory or digital comparator which are preceded by an analog digital convertor, are provided for the storage unit (10) and the comparator (11).

12. A circuit arrangement according to one of the preceding Claims 9 to 11, characterised in that, between the magnetic-field-dependent resistance (7) and the storage unit (10), a preamplifier (9) is connected, one input of which is supplied with the voltage drop across the magnetic-field-dependent resistance (7) and the other input of which is supplied with a reference voltage.

13. A circuit arrangement according to Claims 9 to 12, characterised in that the ferro-magnetic circuit (1) can be opened.

14. A circuit arrangement according to Claim 9, 10, 12, 13 or 14, characterised in that a peak-value memory is provided for the storage unit (10).

**Revendications**

1. Procédé pour mesurer, sans contact, des courants continus et des courants alternatifs, notamment des valeurs instantanées de courant, moyennant l'utilisation d'un circuit ferromagnétique (1), qui comporte un conducteur (12) parcouru par le courant ($I_{mes}$) à mesurer et qui possède un enroulement (2) ainsi qu'un entrefer dans lequel se trouve disposée une résistance (7) dépendant du champ magnétique et parcourue par un courant de commande ($I_{st}$), caractérisé en ce que:

— on détecte et on mémorise les chutes de tension aux bornes de la résistance (7) dépendant du champ magnétique, dans le cas de valeurs crêtes ou d'autres valeurs prédéterminées du courant ($I_{mes}$) à mesurer dans le conducteur (12), lorsque l'enroulement (2) est sans courant,

— après la coupure du courant à mesurer, on compare successivement les chutes de tension mémorisées à la chute de tension aux bornes de la résistance dépendant du champ magnétique, tandis qu'on envoie un courant équivalent ($I_{Ers}$), augmentant en fonction du temps, à travers l'enroulement (2), et

— dans le cas de valeurs identiques des chutes de tension comparées, on détecte le courant instantané dans l'enroulement (2) et on exploite ce courant, multiplié par le nombre de spires, comme mesure du courant ($I_{mes}$) à mesurer.

2. Procédé selon la revendication 1, caractérisé en ce qu'on détermine le courant ($I_{mes}$) à mesurer ou les valeurs instantanées du courant en utilisant une magnétorésistance servant de résistance (7) dépendant du champ magnétique et qui est alimentée par une source de courant (U=, 8).

3. Procédé selon la revendication 1, caractérisé en ce qu'on détermine le courant ($I_{mes}$) à mesurer ou les valeurs instantanées du courant en utilisant un générateur de Hall en tant que résistance (7) dépendant du champ magnétique.

4. Procédé selon la revendication 1 ou 2, caractérisé en ce que l'on utilise un noyau de fer massif pour le circuit ferromagnétique (1).

5. Procédé selon la revendication 1 ou 2, caractérisé en ce qué l'on utilise un noyau de fer lamellé pour un circuit ferromagnétique (1).

6. Procédé selon la revendication 1 ou 2, caractérisé en ce que l'on utilise, pour le circuit ferromagnétique (1), un noyau de ferrite pour des fréquences limites supérieures.

7. Procédé selon l'une des revendications 1 à 6 précédentes, caractérisé en ce qu'un générateur de tension échelonné pas-à-pas commande le courant équivalent ($I_{Ers}$).

8. Procédé selon l'une des revendications 1 à 7 précédentes, caractérisé en ce qu'un amplificateur différentiel (9) amplifie la tension de sortie de la résistance (7) dépendant du champ magnétique et l'amène dans une gamme qui convient pour la mémorisation et la comparaison.

9. Montage pour la mise en oeuvre du procédé selon l'une des revendications 1 à 8, comportant:

— un circuit ferromagnétique (1) comportant un entrefer et qui peut être accouplé au conducteur (12) parcouru par le courant ($I_{mes}$ à mesurer,

— un enroulement (2) disposé dans le circuit ferromagnétique (1),

— une première source de courant (3) servant à alimenter cet enroulement (2),

— une résistance (7) dépendant du champ magnétique et disposée dans l'entrefer,

— une seconde source de courant (U=, 8) servant à alimenter la résistance (7) avec un courant de commande constant ($I_{st}$),

— une unité de mémoire (10) servant à mémoriser la chute de tension ($U_{FP}$) apparaissant à des instants pouvant être respectivement prédéterminés, aux bornes de la résistance (7) pendant le flux du courant ($I_{mes}$) à mesurer,

— un organe de commutation contenu dans l'unité de mémoire (10) et au moyen duquel la chute de tension peut être introduite dans la mémoire de l'unité de mémoire (10),

— un dispositif de commande d'exécution (4) servant à commander l'alimentation de l'enroulement (2) par la première source de courant (3) et la fermeture de l'organe de communation aux instants prédéterminés,

— une unité d'affichage (6) pour les valeurs détectées du courant ($I_{mes}$) à mesurer,

caractérisé en ce que:

— il est prévu un comparateur (11) dont une entrée est raccordée à la sortie de l'unité de mémoire (10) et dont l'autre entrée est chargée par la chute de tension instantanée aux bornes de la résistance (7),

— le dispositif de commande d'exécution (4) est relié, sur le côté entrée, à la chute de tension instantanée et au signal de sortie du comparateur (11) et est agencé de telle sorte que pendant une première phase déterminée par la durée d'application du courant de mesure ($I_{mes}$), l'enroulement (2) est maintenu sans courant et la mémorisation de la chute de tension est réalisée par fermeture de l'organe de commutation, et que pendant une seconde phase, après la coupure du courant ($I_{mes}$) à mesurer, l'enroulement (2) est alimenté par un courant équivalent augmentant en fonction du temps et l'organe de commutation est maintenu ouvert, et

— l'unité de l'affichage (6) est réalisée de maniére à afficher le courant équivalent.

10. Montage selon la revendication 9, caractérisé en ce qu'une mémoire de valeurs analogiques et un comparateur analogique sont prévus pour constituer l'unité de mémoire (10) et le comparateur (11).

11. Montage selon la revendication 9, caractérisé en ce qu'une mémoire de valeurs numériques et un comparateur numérique, en amont duquel est branché un convertisseur analogique/numérique, sont prévus pour former l'unité de mémoire (10) et le comparateur (11).

12. Montage selon l'une des revendications 9 à 11 précédentes, caractérisé en ce qu'entre la résistance (7) dépendant du champ magnétique et l'unité de mémoire (10) est branché un préamplificateur (9) à une entrée duquel est envoyée la chute de tension aux bornes de la résistance (7) dépendant du champ magnétique et à l'autre entrée duquel est envoyée une tension de référence.

13. Montage selon les revendications 9 à 12, caractérisé en ce que le circuit ferromagnétique (1) peut être ouvert.

14. Montage selon les revendications 9, 10, 12, 13 ou 14, caractérisé en ce qu'il est prévu une mémoire de valeurs crêtes pour l'unité de mémoire (10).

# FIG.1

I

30 A

Nullinie

0.2
sec.

t

# FIG.2

U

A
B
C

0.2 V

4  3  2  1      2  3  4      I

100A

FIG.3